# EUROPÄISCHE PATENTSCHRIFT

(11) **EP 0 676 808 B1**
(45) Veröffentlichungstag und Bekanntmachung des Hinweises auf die Patenterteilung: **11.03.1998**
(21) Anmeldenummer: 95105049.1
(22) Anmeldetag: 04.04.1995
(51) Int. Cl.: H01L 27/02

(54) **Integrierte Treiberschaltungsanordnung für ein induktives Lastelement**
Integrated diver circuit arrangement for inductive load element
Dispositif de circuit de commande intégré pour un élément de charge inductif

(30) Priorität: 06.04.1994 DE 4411869
(43) Veröffentlichungstag der Anmeldung: 11.10.1995
(73) Patentinhaber: SIEMENS AKTIENGESELLSCHAFT, 80333 München (DE)
(72) Erfinder: Werner, Wolfgang, Dr.-Ing., D-81545 München (DE)

(56) Entgegenhaltungen:
- DE-C- 2 560 247
- IBM TECHNICAL DISCLOSURE BULLETIN, Bd.19, Nr.2, Juli 1976 Seiten 569 - 570 D.J. FLEMING ET AL.

## Beschreibung

Die Erfindung betrifft eine integrierte Treiberschaltungsanordnung für ein induktives Lastelement mit einem Substrat und einer Mehrzahl isolierter Wannen und mit einem Ausgangsanschluß zum Anschluß des Lastelements.

Integrierte Schaltungsanordnungen mit Leistungstransistoren schalten heute Ströme bis 30 A. Getrieben werden sowohl ohmsche, kapazitive als auch induktive Lasten. In integrierten Leistungsanordnungen mit einem p-Substrat und darin angeordneten n-dotierten Wannen, die die elektrischen Bauelemente aufnehmen, müssen die sich ergebenden pn-Übergänge immer in Sperrichtung vorgespannt sein, damit die Wannen wirksam gegeneinander isoliert werden können. Typischerweise wird deshalb das Substrat mit dem niedrigsten Potential der Schaltung verbunden.

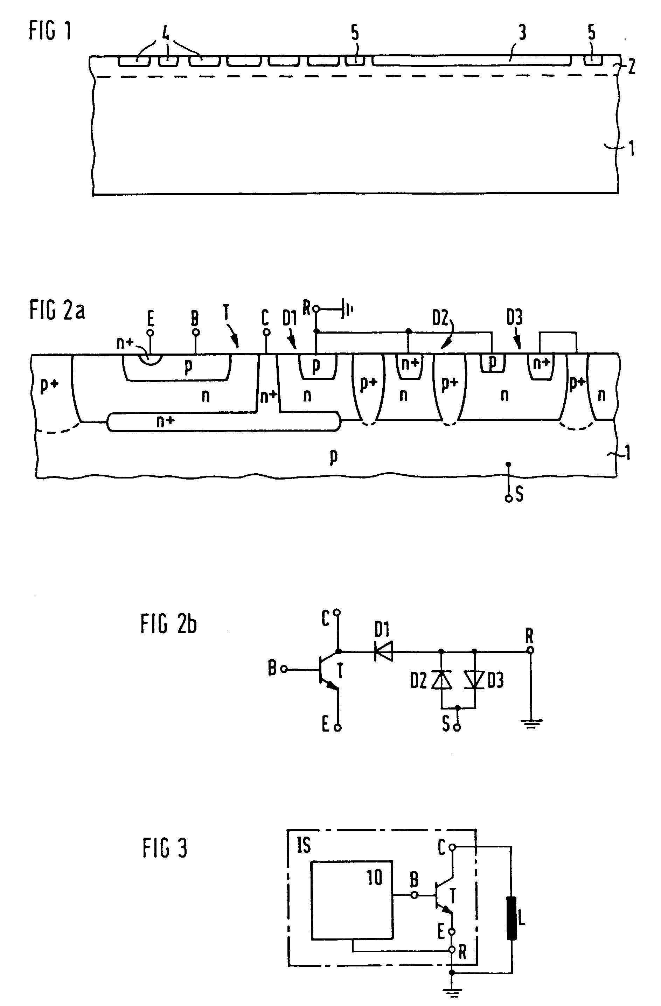

Andererseits ist bekannt, daß induktive Lasten oder Lasten mit induktivem Anteil bei einer plötzlichen Unterbrechung des durch sie fließenden Stroms eine Gegenspannung erzeugen, Fig. 3. Die integrierte Schaltung IS enthält den Leistungstransistor T und dessen Treiberschaltung 10. Am Ausgangsanschluß C ist die induktive Last L angeschlossen, die mit ihrem anderen Anschluß mit einem Bezugspotential verbunden ist. Beim Abschalten des Transistors T nimmt die mit dem Ausgangsanschluß C (Kollektor) verbundene n-Wanne ein negatives Potential an. Dies hat zur Folge, daß ein Minoritätsträgerstrom in der Größenordnung des Schaltstroms in das p-Substrat injiziert wird. Die Minoritätsträger bewegen sich im neutralen Substrat lediglich aufgrund eines Konzentrationsgefälles. Die Chiprückseite und die n-Wannen an der Oberfläche der integrierten Schaltung wirken als Senke für die Ladungsträger. Dabei entstehen sogenannte Querströme. Ein Teil der Minoritätsträger rekombiniert im Substrat. Allerdings ist die Kristallqualität des Substrats im allgemeinen so gut, daß nur geringe Rekombinationsgeschwindigkeiten bzw. daß hohe Trägerlebensdauern auftreten. Als Folge ziehen die n-Wannen, in die die Bauelemente der integrierten Schaltung eingebettet sind, entsprechend große Querströme, was Fehlfunktionen der integrierten Schaltung durch z. B. eine ungewollte Aktivivierung von bipolaren pnp-Transistoren zur Folge hat.

Aus der EP-A 0 284 979 ist das zuvor beschriebene Problem bekannt und dadurch gelöst, daß das Substrat über je eine Diode mit dem Ausgangsanschluß zum Anschluß der induktiven Last bzw. mit dem Referenzanschluß zum Anschluß an ein Referenzpotential verbunden ist.

Die Erfindung löst das vorstehend genannte Problem durch die Merkmale der Patentansprüche 1-4.

Die Erfindung hat den Vorteil, daß eine integrierte Schaltungsanordnung mit den Merkmalen der Ansprüche 1-4 lediglich einen anders aufgebauten Wafer für die Herstellung der integrierten Schaltung benötigt, daß aber ansonsten der Prozeßablauf zur Herstellung der integrierten Schaltung unverändert bleibt.

Ausgestaltungen der Erfindung sind in Unteransprüchen gekennzeichnet.

Die Erfindung wird nachfolgend anhand von Ausführungsbeispielen näher erläutert, wozu auf die Figuren Bezug genommen wird. Es zeigen:
- FIG 1: einen Querschnitt durch einen Wafer mit den erfindungsgemäßen Merkmalen.
- FIG 2a: einen Querschnitt durch einen Wafer zur Erläuterung einer Schaltungsanordnung,
- FIG 2b: ein Ersatzschaltbild zu FIG 2a und
- FIG 3: ein bekanntes Prinzipschaltbild zur Erläuterung des Problems der Erfindung.

Gemäß FIG 1 ist auf einem Substrat 1 eine epitaktische Schicht 2 aufgebracht. In die epitaktische Schicht sind Wannen 3, 4 und 5 eingebracht, in denen die einzelnen Elemente der integrierten Schaltungsanordnung verwirklicht sind. Die Wanne 3 enthält einen Leistungstransistor, während die Wannen 4 Treibertransistoren enthalten. Details des Aufbaus der einzelnen Elemente der integrierten Schaltung sind allgemeines Fachwissen, siehe z. B. das Buch D. Widmann, H. Mader, H. Friedrich: Technologie hochintegrierter Schaltungen, Springer-Verlag, 1988.

Im ersten Ausführungsbeispiel ist das Substrat 1 vom p-Leitfähigkeitstyp mit einer hohen Dotierung gegenüber üblichen p-Substraten, z. B. einer Akzeptordotierung von > 10¹⁷ cm⁻³. Je hoher die Dotierung, desto wirkungsvoller ist das erzielbare Ergebnis. Zum Vergleich besitzen übliche p-Substrate eine Akzeptordotierung von etwa 10¹⁵ cm⁻³. Auf dem p⁺-Substrat ist die epitaktische p-Schicht 2 mit einer Akzeptordotierung von ungefähr 1 x 10¹⁵ cm⁻³ aufgebracht. Die Wannen 3 bis 5 können in dieser epitaktischen Schicht ebenso wie die anschließend herzustellenden Bauelemente ohne eine Veränderung des bei einem p-Substrat verwendeten Herstellungsprozesses für die integrierten Schaltungselemente hergestellt werden. Die Anordnung arbeitet als npn-Transistor mit n-Wanne 3 als Emitter, p-Epi- und p⁺-Substrat als gemeinsamer Basis und Wanne 5 als Kollektor. Das p⁺-Substrat hat eine Wirkung wie ein Spiegel, an dem die Ladungsträger gespiegelt werden und deshalb nicht in das Substrat eindringen.

Beim Abkommutieren einer an dem Ausgangsanschluß der integrierten Schaltungsanordnung angeschlossenen induktiven Last reduziert das durch den p⁺p-Übergang zwischen Substrat 1 und epitaktischer Schicht 2 entstehende Driftfeld die in das Substrat injizierten Minoritätsträger dramatisch. Die Minoritätsträger bewegen sich vorzugsweise lateral in dem Zwischenraum zwischen dem p⁺-Substrat 1 und der n-Wanne 5. In dem Ausführungsbeispiel ist vorgesehen, daß die n-Wanne 5 als Schutzring dient, der die injizierten Minoritätsträger absaugt. Eine Beeinträchtigung der außerhalb des Schutzrings 5 angeordneten elektrischen Elemente findet nicht statt.

Minoritätsträger, die trotzdem in das p⁺-dotierte Substrat eindringen können, haben mit einer erheblich kleineren Trägerlebensdauer als in einem niedriger dotierten p-Substrat zu rechnen und wirken sich deshalb nicht schädlich auf die Funktion der Schaltung aus.

Hinsichtlich der geometrischen Dicke ist vorgesehen, daß die Gesamtdicke des Wafers gemäß FIG 1 etwa 300 µm beträgt und daß der Zwischenbereich der epitaktischen Schicht zwischen den Wannen 3 bis 5 und dem Substrat 1 in der Größenordnung von 3 bis 10 µm liegt.

Ein zweites Beispiel der Erfindung kann ebenfalls anhand der Fig. 1 erläutert werden, mit dem Unterschied, daß nunmehr das Substrat 1 n-dotiert ist und die Wannen 5 keine Ladungsträger absaugen. Die Dotierung des n-Substrats ist für die Querstromunterdrückung unkritisch, so daß sie nach anderen vorgegebenen Gesichtspunkten eingestellt werden kann. Die Schichtdicke und Dotierung der epitaktischen p-Schicht 2 wird typischerweise ähnlich wie in dem ersten Ausführungsbeispiel gewählt.

Im Fall der Minoritätsträgerinjektion über die Wanne 3 zunächst in die epitaktische Schicht 2 und in das Substrat 1 sind die Ladungsträger im n-Substrat Majoritätsträger und damit unschädlich im Hinblick auf das geschilderte Problem.

Ein drittes Beispiel gemäß FIG 2 sieht vor, daß in einem p-dotierten Substrat n-dotierte Wannen gebildet werden, die durch jeweilige hochdotierte p⁺-Isolationsgräben voneinander elektrisch isoliert sind. In einer ersten Wanne sei ein bipolarer Leistungstransistor T mit Emitter E, Basis B und Kollektoranschluß C in üblicher Technik hergestellt. Eine Diode D1 ist als nichtlineares Element in Sperrichtung zwischen der als Kollektor wirkenden n-Wanne und einem Referenzanschluß R zum Anschluß an ein Referenzpotential geschaltet. Dazu wird in der n-Wanne ein pdotierter Bereich hergestellt und mit dem Referenzpotential verbunden. In entsprechender Weise kann selbstverständlich auch bei einem MOS-Transistor der Source oder Drainanschluß über eine derartige Diode D1 an Referenzpotential, d.h. Masse gelegt werden. Bei einer Ladungsträgerinjektion, die zu einer negativen n-Wanne führt, kann der Querstrom über die Diode D1 abfließen. Dies ist jedoch nur dann möglich, wenn das Substrat potentialmäßig mitlaufen bzw. floaten kann. Dazu ist vorgesehen, daß der Referenzanschluß R mit dem Substrat S über zwei antiparallel geschaltete Dioden D2 und D3 verbunden ist.

Die in dem Ausführungsbeispiel näher beschriebene Erfindung schützt die integrierte Schaltung zum Treiben einer induktiven Last wirksam und zuverlässig gegen die beschriebenen Probleme, insbesondere gegen eine Fehlfunktion der Schaltungsanordnung. Darüber hinaus ist die Erfindung einfach und kostengünstig herzustellen, wobei das Herstellverfahren für die integrierten Schaltungselemente typischerweise nicht geändert werden muß, sondern allenfalls eine Änderung im Layout vorgesehen ist. Die eigentliche Prozeßabfolge kann gleich bleiben.

## Patentansprüche

1. Integrierte Treiberschaltungsanordnung
- in einem hochdotierten Substrat (1) mit p-Leitfähigkeit und einer darüber aufgebrachten epitaktischen Schicht (2) gleichen Leitfähigkeitstyps und niedrigerer Dotierung, in der eine Mehrzahl n-dotierter Wannen (3, 4) angeordnet sind,
- mit einem Leistungstransistor (T), der in einer der Wannen (3) angeordnet ist und einen Ausgangsanschluß zum Anschluß eines induktiven Lastelementes aufweist, und
- mit einem n-dotierten Gebiet (5) in der epitaktischen Schicht (2), das die dem Ausgangsanschluß zugeordnete Wanne (3) lateral umschließt.

2. Anordnung nach Anspruch 1,
**dadurch gekennzeichnet**,
daß die Akzeptordotierung des Substrats (1) wenigstens zwei Größenordnungen größer als die Akzeptordotierung der epitaktischen Schicht (2) ist.

3. Anordnung nach einem der Ansprüche 1 bis 2,
**dadurch gekennzeichnet,**
daß der Leistungstransistor (T) ein Bipolartransistor ist.

4. Verwendung einer integrierten Treiberschaltungsanordnung mit den Merkmalen eines der Patentansprüche 1 bis 3 zum Treiben eines induktiven Lastelements.

## Claims

1. Integrated driver circuit arrangement
- in a highly doped substrate (1) with p-conductivity and epitaxial layer (2), applied thereon, of an identical conductivity type and with a lower level of doping, in which a plurality of n-doped wells (3, 4) are arranged,
- having a power transistor (T) which is arranged in one of the wells (3) and has an output connection for connecting an inductive load element, and
- having an n-doped region (5) in the epitaxial layer (2) which surrounds the sides of the well (3) assigned to the output connection.

2. Arrangement according to Claim 1, characterized in that the acceptor doping of the substrate (1) is at least two orders of magnitude greater than the acceptor doping of the epitaxial layer (2).

3. Arrangement according to one of Claims 1 to 2, characterized in that the power transistor (T) is a bipolar transistor.

4. Use of an integrated driver circuit arrangement having the features of one of Patent Claims 1 to 3 for driving an inductive load element.

## Revendications

1. Dispositif de circuit intégré d'attaque
- dans un substrat (1) à conductivité de type p et à dopage élevé et dans une couche épitaxiale (2) placée dessus, de même type de conductivité et à dopage inférieur, dans laquelle sont agencés plusieurs creux (3, 4) à dopage n,
- comportant un transistor de puissance (T) qui est agencé dans un des creux (3) et qui comporte une borne de sortie destinée au raccordement d'un élément de charge inductif, et
- une région (5) à dopage n qui est agencée dans la couche épitaxiale (2) et qui entoure latéralement le creux (3) associé à la borne de sortie.

2. Dispositif selon la revendication 1,
caractérisé par le fait que le dopage accepteur du substrat (1) est au moins de deux ordres de grandeur plus grand que le dopage accepteur de la couche épitaxiale (2).

3. Dispositif selon l'une des revendications 1 à 2,
caractérisé par le fait que le transistor de puissance (T) est un transistor bipolaire.

4. Utilisation d'un dispositif de circuit intégré d'attaque ayant les caractéristiques d'une des revendications 1 à 3 pour commander un élément de charge inductif.
